# EUROPÄISCHE PATENTANMELDUNG

(11) **EP 4 422 357 A1**
(43) Veröffentlichungstag der Anmeldung: **28.08.2024**
(21) Anmeldenummer: 23157799.0
(22) Anmeldetag: 21.02.2023
(51) Int. Cl.: H05K 1/02, H05K 1/11, H05K 3/34, H05K 3/46

(54) **LEITERPLATTE, ELEKTRONISCHE VORRICHTUNG UND VERFAHREN**

(71) Anmelder: Fraunhofer-Gesellschaft zur Förderung der angewandten Forschung e.V., 80686 München (DE)
(72) Erfinder: Kai, WESTHÖFER, 53343 Wachtberg (DE)
(74) Vertreter: 2SPL Patentanwälte PartG mbB

(57) **Zusammenfassung**

Ausführungsbeispiele der vorliegenden Erfindung schaffen eine Leiterplatte umfassend einen Schichtstapel 100. Der Schichtstapel 100 umfasst eine Mehrzahl an Kernschichten 112a; 112b und eine Mehrzahl an Leitschichten 110a; 110b. Jede Leitschicht der Mehrzahl an Leitschichten ist elektrisch leitfähig. Ferner umfasst die Leiterplatte eine auf dem Schichtstapel angeordnete Leiterbahnschicht 110c, umfassend eine Leiterbahn 128. Die Leiterbahn 128 weist einen ersten Leiterbahnabschnitt 130 in einem ersten Bereich 120 und einen zweiten Leiterbahnabschnitt 132 in einem zweiten Bereich 122 auf. Eine ausgesparte Leitschicht 110b der Mehrzahl an Leitschichten weist in dem ersten Bereich 120 eine Aussparung 140 auf.

## Beschreibung

Ausführungsbeispiele der vorliegenden Erfindung beziehen sich auf eine Leiterplatte, eine elektronische Vorrichtung und ein Verfahren zur Herstellung einer Leiterplatte. Insbesondere aber nicht ausschließlich, beziehen sich Ausführungsbeispiele der vorliegenden Erfindung auf eine Verbesserung einer Anpassung der Leiterplatte an verschiedene Komponenten, die in einem System, beispielsweise einer elektronischen Vorrichtung, angeordnet werden.

Beim Design einer Leiterplatte können mehrere Faktoren von Interesse sein, beispielsweise eine Impedanz oder eine geometrische Abmessung eines Kontaktbereichs. Beispielsweise können Kontaktbereiche von verschiedenen Komponenten, z. B., eine Seele eines Steckers, verschiedene Abmessungen aufweisen. Durch eine Anpassung der Leiterplatte an die verschiedenen Kontaktbereiche kann es zu einer Abweichung einer Impedanz der Kontaktbereiche der Leiterplatte von der Systemimpedanz kommen. Beim Design der Leiterplatte ist dann immer eine Abwägung zwischen einer erforderlichen Impedanz der Leiterbahn und einer erforderlichen Abmessung des Kontaktbereichs für die Komponenten erforderlich. Es besteht daher ein Bedarf daran ein Design einer Leiterplatte zu verbessern.

Ausführungsbeispiele basieren auf dem Kerngedanken, dass ein Design einer Leiterplatte angepasst werden kann, indem in bestimmten Leitschichten der Leiterplatte Aussparungen vorgesehen werden. Durch die Aussparungen der Leitschichten der Leiterplatte können verschiedene Leiterbahnabschnitte an verschiedene Komponenten angepasst werden. Insbesondere kann durch die Aussparung eine Anpassung der Impedanz der Leiterbahn verbessert werden. Dadurch können beispielsweise strukturell verschiedene Leiterbahnabschnitte dieselbe Impedanz aufweisen. Beispielsweise kann ein Leiterbahnabschnitt an Komponenten für Hochleistungsbetrieb angepasst werden, welche normalerweise einen größeren Kontaktbereich aufweisen.

Ausführungsbeispiele betreffen eine Leiterplatte umfassend einen Schichtstapel. Der Schichtstapel umfasst eine Mehrzahl an Kernschichten und eine Mehrzahl an Leitschichten. Jede Leitschicht der Mehrzahl an Leitschichten ist elektrisch leitfähig. Ferner umfasst die Leiterplatte eine auf dem Schichtstapel angeordnete Leiterbahnschicht, umfassend eine Leiterbahn. Die Leiterbahn weist einen ersten Leiterbahnabschnitt in einem ersten Bereich und einen zweiten Leiterbahnabschnitt in einem zweiten Bereich auf. Eine ausgesparte Leitschicht der Mehrzahl an Leitschichten weist in dem ersten Bereich eine Aussparung auf. Durch die Aussparung der ausgesparten Leitschicht ist im ersten Bereich zumindest eine Kemschicht mehr als im zweiten Bereich relevant für die Berechnung der Impedanz der Leiterbahn. Die Impedanz für den ersten Leiterbahnabschnitt kann daher von der Impedanz für den zweiten Leiterbahnabschnitt bei identischen Abmessungen der beiden Leiterbahnabschnitte abweichen. Dadurch kann eine Abmessung des ersten Leiterbahnabschnitts verschieden vom zweiten Leiterbahnabschnitt gewählt werden, und zeitgleich eine Impedanz identisch sein. Dementsprechend können die beiden Leiterbahnabschnitte an verschiedenen Komponenten, bzw. verschieden Kontaktbereiche von Komponenten angepasst werden. Dadurch können insbesondere Verbindungen der Leiterplatte mit anderen Komponenten verbessert werden, ohne dass eine Impedanzfehlanpassung für die Leiterplatte, bzw. die einzelnen Leiterbahnabschnitte auftritt.

Ausführungsbeispiele betreffen eine Leiterplatte umfassend einen Schichtstapel. Der Schichtstapel umfasst einen ersten Stapel und einen auf dem ersten Stapel angeordneten zweiten Stapel. Der erste Stapel umfasst eine erste Leitschicht, eine zweite Leitschicht und eine zwischen der ersten Leitschicht der zweiten Leitschicht angeordnete Kemschicht. Der zweite Stapel umfasst eine erste Leitschicht, eine zweite Leitschicht und eine zwischen der ersten Leitschicht und der zweiten Leitschicht angeordnete Kemschicht. Die zweite Leitschicht des ersten Stapels und die erste Leitschicht des zweiten Stapels weisen in einem ersten Bereich eine Aussparung auf. Die zweite Leitschicht des zweiten Stapels umfasst eine Leiterbahn, die in dem ersten Bereich einen ersten Leiterbahnabschnitt und in einem zweiten Bereich einen zweiten Leiterbahnabschnitt aufweist. Durch die Aussparung im ersten Bereich der zweiten Leitschicht des ersten Stapels und der ersten Leitschicht des zweiten Stapels kann eine Dicke einer isolierenden Schicht für die Leiterplatte variiert werden. Die Dicke der isolierenden Schicht im ersten Bereich kann im Vergleich zur isolierenden Schicht im zweiten Bereich vergrößert werden. Im ersten Bereich kann sich die Dicke der isolierenden Schicht aus der Dicke der Kemschicht der ersten Lage und der Dicke der Kemschicht der zweiten Lage ergebe. Dahingegen kann sich die Dicke der isolierenden Schicht der zweiten Lage lediglich durch die Dicke der Kemschicht der zweiten Lage ergeben. Dadurch kann eine Impedanz des ersten Leiterbahnabschnitts relativ zum zweiten Leiterbahnabschnitt verändert werden. Dementsprechend kann alternativ bei gleicher Impedanz eine Abmessung des ersten Leiterbahnabschnitts verschieden zu einer Abmessung des zweiten Leiterbahnabschnitts gewählt werden. Durch die Möglichkeit die Abmessung des ersten Leiterbahnabschnitts relativ zum zweiten Leiterbahnabschnitt zu verändern, kann bei konstanter Systemimpedanz eine Anpassung an verschiedene Komponenten erfolgen.

Ausführungsbeispiele betreffen ein Verfahren zur Herstellung einer Leiterplatte. Das Verfahren umfasst Formen einer ersten Leitschicht und Formen einer ersten Kemschicht auf der ersten Leitschicht. Ferner umfasst das Verfahren Formen einer zweiten Leitschicht auf der ersten Kemschicht. Die zweite Leitschicht überdeckt die erste Leitschicht in einer Draufsicht nur in einem ersten Bereich. Ferner umfasst das Verfahren Formen einer zweiten Kemschicht auf der zweiten Leitschicht und Formen einer Leitbahnschicht, umfassend eine Leiterbahn.

Ausführungsbeispiele werden nachfolgend bezugnehmend auf die beiliegenden Figuren näher erläutert:
Fig. 1a und 1b zeigen eine schematische Seitenansicht bzw. Draufsicht eines Schichtstapels einer Leiterplatte;
Fig. 2 zeigt eine schematische Quersicht eines Schichtstapels einer Leiterplatte;
Figs. 3a-3e zeigen schematische Draufsichten auf verschiedene Stapel eines Schichtstapels;
Fig. 3f zeigt eine beispielshafte Querschnittsansicht eines Schichtstapels;
Fig. 4 zeigt eine elektronische Vorrichtung umfassend eine Leiterplatte; und
Fig. 5 zeigt eine schematische Darstellung eines Beispiels eines Verfahrens.

Verschiedene Ausführungsbeispiele werden nun ausführlicher unter Bezugnahme auf die beiliegenden Zeichnungen beschrieben, in denen einige Ausführungsbeispiele dargestellt sind. In den Figuren können die Dickenabmessungen von Linien, Schichten und/oder Regionen um der Deutlichkeit Willen übertrieben dargestellt sein.

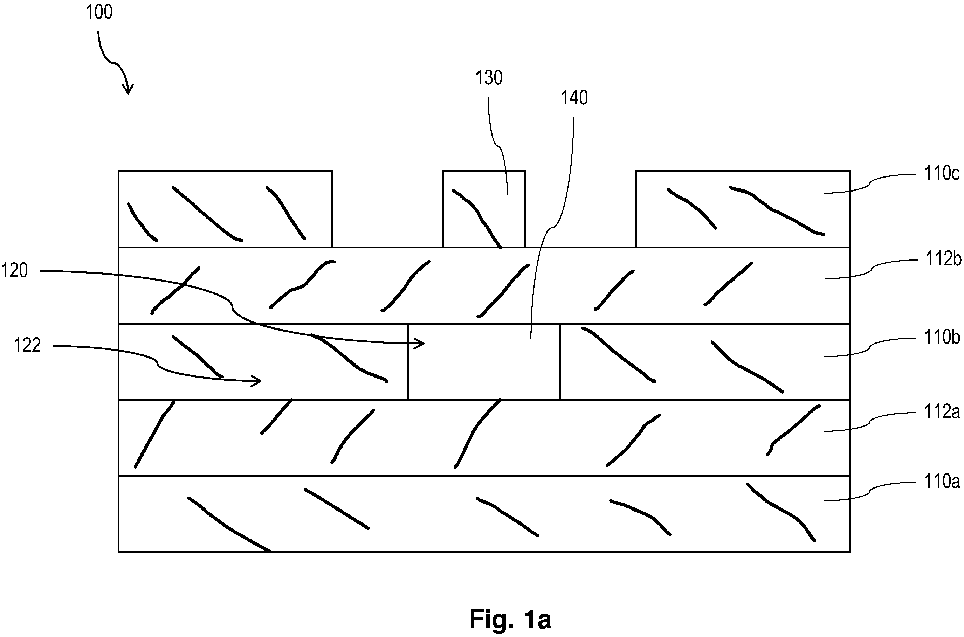

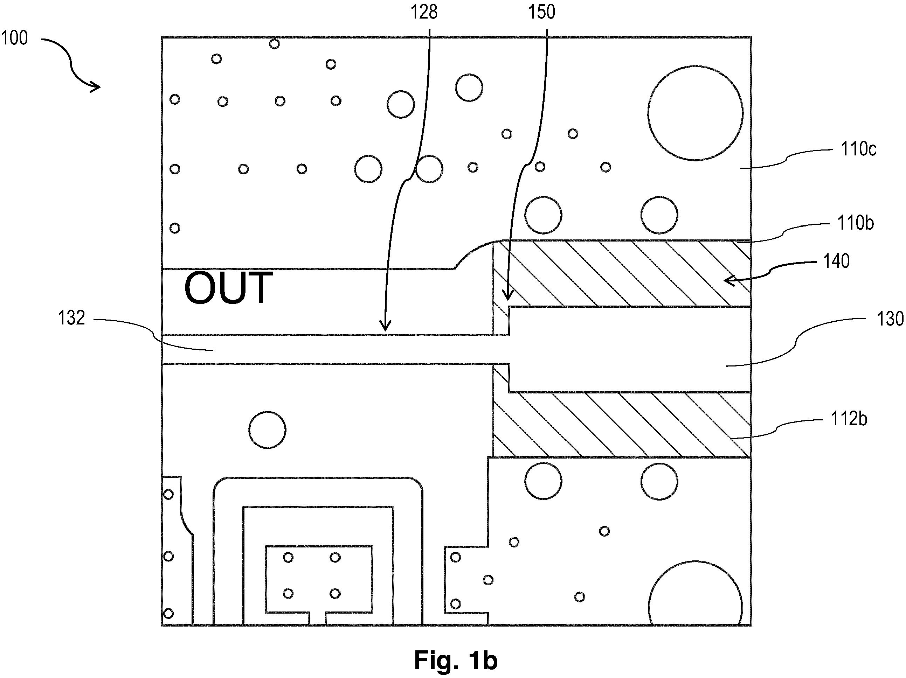

Fig. 1a und 1b zeigen eine schematische Seitenansicht bzw. eine Draufsicht eines Schichtstapels 100 einer Leiterplatte. Der Schichtstapel 100 umfasst eine Mehrzahl an Kernschichten 112a, 112b. Eine Kemschicht der Mehrzahl an Kernschichten 112a, 112b kann eine isolierende Schicht sein. Die Kemschicht 112a, 112b kann dazu dienen eine elektrische Komponente und/oder Leiterbahnen innerhalb einer Schaltung voneinander zu isolieren und/oder zu schützen. Insbesondere kann die Kemschicht 112a, 112b verhindern, dass elektrischer Strom von einer Leitschicht auf eine andere übertragen wird, und trägt somit zur elektrischen Sicherheit und zuverlässigen Funktion der Schaltung bei. Die Kemschicht 112a, 112b kann aus verschiedenen Materialien bestehen, wie beispielsweise Kunststoffen, Epoxiden, Keramiken oder Glasschichten. Eine Dicke der Kemschicht 112a, 112b (bzw. der isolierenden Schicht) kann für die Berechnung der Impedanz der Leiterbahn 128, bzw. der einzelnen Leiterbahnabschnitte 130, 132 von Bedeutung sein.

Für die Berechnung der Impedanz im zweiten Bereich 122 kann, aufgrund der Abschirmung durch die ausgesparte Leitschicht 110b, lediglich die Kemschicht 112b von Bedeutung sein. Die Kemschicht 112a kann durch die ausgesparte Leitschicht 110b im zweiten Bereich abgeschirmt werden. Die Dicke der isolierenden Schicht für den zweiten Bereich kann sich damit aus der Dicke der Kernschicht 112b ergeben.

Für die Berechnung der Dicke der isolierenden Schicht im ersten Bereich können beide Kernschichten 112a, 112b von Bedeutung sein. Insbesondere können beide Kernschichten 112a, 112b eine isolierende Schicht formen. Eine Dicke der isolierenden Schicht kann sich im ersten Bereich 120 damit aus den Dicken der beiden Kernschichten 112a, 112b ergeben.

Ferner umfasst der Schichtstapel 100 eine Mehrzahl an Leitschichten 110a, 110b. Jede Leitschicht der Mehrzahl an Leitschichten 110a, 110b ist leitfähig. Eine Leitschicht 110a, 110b ist ein elektrischer Leiter, der verwendet wird, um elektrische Signale innerhalb einer Schaltung zu übertragen. Eine Leitschicht kann aus verschiedenen Materialien hergestellt werden, wie beispielsweise Kupfer, Aluminium oder Edelmetallen, und kann verschiedene Formen und Abmessungen aufweisen.

Ferner umfasst die Leiterplatte eine auf dem Schichtstapel 100 angeordnete Leiterbahnschicht 110c. Die Leiterbahnschicht 110c umfasst eine Leiterbahn 128. Die Leiterbahnschicht 110c kann eine der Mehrzahl Leitschichten sein. Beispielsweise kann die Leiterbahnschicht 110c eine Leitschicht sein, die an einer Oberfläche des Schichtstapel 100 angeordnet ist. Alternativ kann die Leiterbahnschicht 110c verschieden von der Mehrzahl an Leitschichten sein. Die Leiterbahnschicht 110c (und somit auch die Leiterbahn 128) 110c kann aus verschiedenen Materialien hergestellt werden, wie beispielsweise Kupfer, Aluminium oder Edelmetallen, und kann verschiedene Formen und Größen aufweisen.

Zur Anordnung einer Komponente auf der Leiterplatte kann es erforderlich sein, eine Breite der Leiterbahn 130 anzupassen. Beispielsweise kann eine Komponente für Hochleistungsbetrieb, zum Beispiel ein Hochleistungssteckverbinder für Hochfrequenzverstärker, eine andere Geometrie aufweisen als eine Komponente für Normalbetrieb. Ein Kontaktbereich einer Komponente für Hochleistungsbetrieb kann beispielsweise breiter sein als ein Kontaktbereich einer Komponente für Normalbetrieb. Dementsprechend kann es für beide Komponenten unterschiedliche ideale Abmessungen der Leiterbahn 128 zur Kontaktierung geben. Deshalb kann es erforderlich sein, verschiedene Leiterbahnabschnitte vorzusehen.

Die Leiterbahn 128 weist einen ersten Leiterbahnabschnitt 130 in einem ersten Bereich 120 und einen zweiten Leiterbahnabschnitt 132 in einem zweiten Bereich 122 auf. Durch die unterschiedlichen Leiterbahnabschnitte 130, 132 können Komponenten mit verschiedenen Anforderungen an eine Kontaktbereiche vorteilhaft mit der Leiterbahn 128 kontaktiert werden. Dadurch kann insbesondere ein Kontakt zwischen den Komponenten und der Leiterplatte verbessert werden.

Die Impedanz der Leiterbahn 128, beispielsweise eines Mikrostreifenleiters, hängt von verschiedenen Parametern ab, zum Beispiel, vom Widerstand (R), der Induktivität (L), der Kapazität (C) entlang der Leiterbahn 128. Diese Größen hängen von verschiedenen Faktoren ab, wie der Breite und Dicke der Leiterbahn 128, dem Abstand zu benachbarten Leiterbahnen, dem Material und der Dicke der Kernschicht 112a, 112b und dem Frequenzbereich, in dem das Signal übertragen wird. Aufgrund der unterschiedlichen Leiterbahnabschnitte 130, 132 kann es zu einer Impedanzfehlanpassung für einen der beiden Leiterbahnabschnitte 130, 132 kommen.

Um dieser Impedanzfehlanpassung entgegenzuwirken, weist eine ausgesparte Leitschicht 110b der Mehrzahl an Leitschichten 110a, 110b in dem ersten Bereich 120 eine Aussparung 140 auf. Durch die Aussparung 140 kann eine Dicke der wirksamen Kernschicht verändert werden. Durch die Aussparung 140 können die beiden Kernschichten 112a, 112b eine isolierende Schicht formen. Durch die isolierende Schicht kann die Leiterbahn 128 in den verschiedenen Leiterbahnabschnitten 130, 132 dieselbe Impedanz bei unterschiedlichen Abmessungen aufweisen. Beispielsweise kann bei identischer Impedanz eine Breite des ersten Leiterbahnabschnitts 130 verschieden von einer Breite des zweiten Leiterbahnabschnitts 132 sein. Eine Aussparung 140 kann eine Öffnung in der Leitschicht sein. Die Aussparung 140 kann beispielsweise in der als Masse fungierenden Leitschicht bzw. deren Kupferstruktur gebildet sein.

Die Permittivität der isolierenden Schicht bzw. der Kernschichten 112a, 112b (die von Bedeutung sind) beeinflusst die Übertragung elektrischer Signale entlang der Leiterbahn 128. Bei einer höheren Permittivität ergibt sich bei gleicher geometrischer Abmessung eine geringere Impedanz. Durch die Aussparung 140 kann für den ersten Bereich eine unterschiedliche effektive Permittivität als für den zweiten Bereich vorliegen. Insbesondere kann die Aussparung dazu führen, dass eine effektive Permittivität im ersten Bereich geringer ist als im zweiten Bereich. Die geringere effektive Permittivität im ersten Bereich kann zu einer höheren Impedanz im ersten Bereich führen. Insbesondere, kann durch die Aussparung 140 ein Wellendurchgang einer elektrischen Welle im ersten Bereich 120 ausgehend von dem Leiterbahnabschnitt 130c bis zur (untersten) Leitschicht 110a erfolgen. Durch die Aussparung 140 kann also eine Impedanz des ersten Leiterbahnabschnitts 130 aufgrund einer verringerten effektiven Permittivität erhöht werden. Insbesondere kann eine Dicke der isolierenden Schicht im ersten Bereich 120 größer sein als eine Dicke der isolierenden Schicht im zweiten Bereich 122. Beispielsweise kann die Berechnung der Impedanz des ersten Leiterbahnabschnitts 130 von einer Dicke der beiden Kernschichten 112a, 112b abhängen. Beispielsweise kann die Berechnung der Impedanz des zweiten Leiterbahnabschnitts 132 nur von der Dicke der Kemschicht 112b abhängen. Die zur Berechnung der Impedanz des ersten Leiterbahnabschnitts 130 notwendige Dicke der isolierenden Schicht kann sich also aus der Summe der Dicke der beiden Kernschichten 112a, 112b ergeben. Die zur Berechnung der Impedanz des zweiten Leiterbahnabschnitts 132 notwendige der Dicke kann sich hingegen aus der Dicke der entsprechenden Kemschicht 112b ergeben.

Dadurch kann eine veränderte Impedanz aufgrund einer veränderten Abmessung des ersten Leiterbahnabschnitts 130 kompensiert werden. Beispielsweise kann durch einen breiteren Leiterbahnabschnitt 130 eine geringere Stromdichte, eine höhere Kapazität eine geringe Selbstinduktion vorliegen, was zu einer geringeren Impedanz führen kann. Die verringerte Impedanz hervorgerufen durch einen breiteren Leiterbahnabschnitt 130 kann also durch die Aussparung 140 kompensiert werden. Durch eine geeignete Wahl der Dicke der isolierenden Schicht, beispielsweise durch eine geeignete Anzahl an Kernschichten bzw. Leitschichten mit Aussparung, kann eine Impedanzanpassung an eine benötigte Abmessung eines Kontaktbereichs einer Komponente erfolgen.

Dadurch kann der Schichtstapel 100 für Komponenten verschiedenen Erfordernissen, beispielsweise mit unterschiedlichen Abmessungen der Kontaktbereiche, vorteilhaft designt werden. Beispielsweise können auf Leiterplatte vorteilhaft verschiedenen Komponenten mit verschiedenen Kontaktbereichen angeordnet werden bzw. mit dieser elektrisch kontaktiert werden. Beispielsweise kann ein Stecker auf einen geeigneten Leiterbahnabschnitt 130 direkt aufgelötet werden. Dadurch kann ein unsicherer und schlechter mechanischer Kontakt wie er bei einer zu dünnen Leiterbahn entstehen kann, vermieden werden. Ferner kann dadurch eine Qualität des elektrischen Kontaktes gewährleistet werden. Es können also insbesondere Kontaktierungsprobleme vermieden werden.

Außerdem kann der Leiterbahnabschnitt 130 an den von einem Hersteller empfohlenen Footprint, also die Abmessung eines Kontaktbereichs, wie z. B., die Seele eines Steckers, angepasst werden. Dieser empfohlene Footprint kann beispielsweise deutlich breiter sein als die Breite des Leiterbahnabschnitts 132. Dadurch würde die Impedanz deutlich vom restlichen Systemdesign, beispielsweise 50 Ohm, abweichen. Dies kann zu Reflexionen und damit einhergehenden elektrischen Verlusten führen. Durch die Verwendung verschiedener Leiterbahnabschnitt 130, 132 können diese elektrischen Verluste verringert oder vermieden werden. Insbesondere kann ein bei hochkompakten Verstärkern mit sehr hoher Leistung entstehender Gegensatz zwischen Footprint und Impedanz durch die Verwendung der beiden Leiterbahnabschnitte 130, 132 vermieden werden.

Durch den vorliegenden Multilagenaufbau des Schichtstapel 110 und die Aussparung 140 kann eine Breite der Leiterbahn 128, die für die Systemimpedanz angepasst ist, zwei verschiedenen Werte annehmen. Dadurch kann ein Design der Leiterplatte an verschiedene Komponenten angepasst werden. Beispielsweise könnte eine Komponente mit einem Kontaktbereich mit einem großen Footprint (beispielsweise eine breite Seele) unter Beibehaltung der Systemimpedanz an einem verbreiteten Leiterbahnabschnitt (beispielsweise dem ersten Leiterbahnabschnitt 130) angeordnet bzw. elektrisch mit diesem kontaktiert werden.

Diese effektiv an die Impedanz angepasste Leiterbahnbreite im ersten Bereich, z. B. eine breitere Breite der Leiterbahn, kann durch die Aussparung 140 ermöglicht werden. Insbesondere kann die Aussparung 140 den ersten Bereich 120 definieren. Beispielsweise kann der erste Leiterbahnabschnitt 130 in dem Bereich der Aussparung 140 geformt sein. Beispielsweise kann am Rand des ersten Bereichs 120 bzw. der Aussparung 140 ein Übergang 150 der Breite der Leiterbahn 128 existieren. Durch den Übergang 150 der Breite kann die Leiterbahn 128 für den ersten Bereich 120 und den zweiten Bereich 122 dieselbe Impedanz aufweisen.

Durch den Übergang 150 der Breite in der Leiterbahn 128 kann die Leiterplatte für verschiedene Komponenten mit unterschiedlichen Kontaktbereichen verwendet werden. Dadurch kann gleichzeitig eine Impedanzanpassung an eine Systemimpedanz und ein vorteilhafter mechanischer und/oder elektrischer Kontakt zwischen Leiterplatte und einem Kontaktbereich, zum Beispiel einer Seele eines Steckers, ermöglicht werden. Der Übergang 150 der Breite in der Leiterbahn 128 bedeutet, dass eine Breite der Leiterbahn 128 vor dem Übergang 150 der Breite verschieden ist von einer Breite der Leiterbahn 128 nach dem Übergang 150 der Breite. Der Übergang 150 der Breite kann ein abrupter Übergang, beispielsweise ein Sprung wie in Fig. 1b gezeigt, sein. Der Übergang 150 der Breite kann also zu einer sprunghaften bzw. stufenartigen Erhöhung der Breite der Leiterbahn 128 führen. Alternativ kann der Übergang 150 der Breite z. B., linear oder sinusförmig erhöht verlaufen. Die Breite der Leiterbahn kann also beispielsweise im durch den Übergang 150 der Breite kontinuierlich erhöht werden.

In einem Ausführungsbeispiel kann der Schichtstapel 100 einen ersten Stapel und einen auf dem ersten Stapel angeordneten zweiten Stapel umfassen. Der erste Stapel und der zweite Stapel kann jeweils eine erste Leitschicht, eine zweite Leitschicht der Mehrzahl an Leitschichten und eine zwischen der ersten Leitschicht und der zweiten Leitschicht angeordnete Kemschicht der Mehrzahl an Kernschichten umfassen. Beispielsweise kann ein Stapel eine funktionelle Einheit des Schichtstapel darstellen. Ein Schichtstapel kann aus einer beliebigen Anzahlanlagen bestehen. Die Aussparungen 140 in den verschiedenen Leitschichten der verschiedenen Stapel kann derart angeordnet, dass die Kernschichten der einzelnen Stapel für eine Berechnung der Impedanz zusammenwirken (wie oben beschrieben). Insbesondere können die Kernschichten der einzelnen Stapel im Bereich der Aussparung 140 eine isolierende Schicht formen.

Insbesondere kann die ausgesparte Leitschicht 110b identisch sein zu der zweiten Leitschicht des ersten Stapels oder der ersten Leitschicht des zweiten Stapels. Der Schichtstapel der die Mehrzahl an Kernschichten 112a, 1112b, die Mehrzahl an Leitschichten (110a, 110b) und die Leiterbahnschicht 110c umfasst kann also insbesondere dem ersten Stapel und dem zweiten Stapel aufgebaut sein. Beispielsweise umfasst der zweite Stapel die Leiterbahnschicht 110c. Die Leiterbahnschicht 110c kann identisch sein zu der zweiten Leitschicht des zweiten Stapels. Insbesondere kann die zweite Leitschicht des zweiten Stapels die Leiterbahnschicht 110c formen.

Durch Aussparung verschiedener Leitschichten, beispielsweise sämtlicher Leitschichten mit Ausnahme der untersten Leitschicht (also der ersten Leitschicht des ersten Stapels) und der obersten Leitschicht (beispielsweise der zweiten Leitschicht des zweiten Stapels) kann eine Anpassung der Impedanz in dem ersten Bereich 120 erfolgen.

Es kann ein Aufbau mit beliebig vielen Stapeln verwendet werden. Insbesondere kann eine Anzahl an Stapeln von einer benötigten Dicke einer resultierenden isolierenden Schicht abhängen. Beispielsweise kann ein Aufbau mit fünf Stapeln und zwei verschiedenen resultierenden Dicken von isolierenden Schichten verwendet werden. Dies kann erreicht werden, in dem der zweite Stapel, der dritte Stapel und der vierte Stapel eine Aussparung jeder Leitschicht und der erste Stapel und der fünfte Stapel der jeweiligen zweiten Leitschicht (erste Stapel) bzw. ersten Leitschicht (fünfte Stapel) aufweist. Abhängig von der Leiterbahntechnologie kann die unterste Leitschicht, also die erste Leitschicht des ersten Stapels als Masseschicht vollflächig vorgesehen sein. Die Masseschicht kann also insbesondere keine Aussparung aufweisen. Die Masseschicht kann vor allem für Mikrostreifenleiter verwendet werden, insbesondere für geerdete koplanare Wellenleiter.

Alternativ kann auch die erste Leitschicht des ersten Stapels eine Aussparung aufweisen, beispielsweise für nicht geerdete koplanare Wellenleiter. Für nicht geerdete koplanare Wellenleiter kann insbesondere der Abstand der Leiterbahn 128 zu anderen Strukturen der Leiterbahnschicht 110c für die Berechnung der Impedanz ein wichtiger Parameter sein.

In einem Ausführungsbeispiel kann eine Impedanz des ersten Leiterbahnabschnitts 130 von einem Abstand des ersten Leiterbahnabschnitts 130 zu einer unausgesparten Leitschicht 110a der Mehrzahl an Leitschichten und eine Impedanz des zweiten Leiterbahnabschnitts 132 von einem Abstand des zweiten Leiterbahnabschnitts 132 zu der ausgesparten Leitschicht 110b der Mehrzahl an Leitschichten abhängen. Der Abstand des ersten Leiterbahnabschnitts 130 zu der unausgesparten Leitschicht 110a der Mehrzahl an Leitschichten kann von einer Dicke einer ersten Kernschichten 112a und einer Dicke einer zweiten Kemschicht 112b abhängen. Der Abstand des zweiten Leiterbahnabschnitts 132 zu der ausgesparten Leitschicht 110b der Mehrzahl an Leitschichten kann von einer Dicken der zweiten Kernschicht 112b abhängen.

Beispielsweise kann in einem Ausführungsbeispiel eine Impedanz des ersten Leiterbahnabschnitts 130 von einer Dicke der Kemschicht des ersten Stapels und einer Dicke der Kemschicht des zweiten Stapels und eine Impedanz des zweiten Leiterbahnabschnitts von einer Dicke der Kemschicht des zweiten Stapels abhängen.

Dadurch kann wie oben beschrieben eine Dicke der isolierenden Schicht variiert werden. Insbesondere kann sich eine Dicke der isolierenden Schicht aus einer Mehrzahl an Kernschichten (beispielsweise der Kemschicht des ersten Stapels und der Kemschicht des zweiten Stapels) ergeben. Die Mehrzahl an Kernschichten und die Mehrzahl an Leitschichten bzw. eine Anzahl der Stapel können/kann also dermaßen gewählt werden, dass eine Dicke der isolierenden Schicht im ersten Bereich an eine anzuordnende Komponente angepasst werden kann.

In einem Ausführungsbeispiel kann eine Breite der Leiterbahn 128 des ersten Leiterbahnabschnitts 130 größer sein als eine Breite der Leiterbahn 128 des zweiten Leiterbahnabschnitts 132. Dadurch kann, wie oben beschrieben, eine durch eine dickere isolierende Schicht hervorgerufene erhöhte Impedanz ausgeglichen werden. Alternativ kann die Breite der Leiterbahn 128 in dem ersten Leiterbahnabschnitt 130 kleiner sein als eine Breite der Leiterbahn 128 in dem zweiten Leiterbahnabschnitt 132. Beispielsweise können die Kernschichten eine Dielektrizitätskonstante aufweisen, bei der für eine größere Dicke eine Impedanz für die Leiterbahn 128 abnimmt. Je dicker die Kemschicht bzw. die isolierende Schicht ist, umso niedriger kann die elektrische Feldstrahlung, die von der Leiterbahn 128 ausgeht, sein. Dies kann zu einer geringeren Impedanz führen, ja nachdem wie die Dielektrizitätskonstante der Kernschichten gewählt wird. Dementsprechend würde für den ersten Bereich 120, also den ersten Leiterbahnabschnitt 130, die Impedanz abnehmen. Dadurch könnte der erste Leiterbahnabschnitt 130 schmaler als der zweite Leiterbahnabschnitt 132 ausgebildet werden.

Die Dielektrizitätskonstanten der einzelnen Kernschichten können identisch sein. In einem Ausführungsbeispiel kann die Dielektrizitätskonstante der Kemschicht des ersten Stapels identisch sein zu einer Dielektrizitätskonstante der Kemschicht des zweiten Stapels. Alternativ können die Dielektrizitätskonstanten der einzelnen Kernschichten unterschiedlich sein. In einem Ausführungsbeispiel kann die Dielektrizitätskonstante der Kemschicht des ersten Stapels verschieden sein von einer Dielektrizitätskonstante der Kemschicht des zweiten Stapels. Dadurch können sich insbesondere größere Freiheitsgrade für ein Design des Schichtstapels ergeben. Beispielsweise kann die Dielektrizitätskonstante der Kernschicht des ersten Stapels verschieden von der Dielektrizitätskonstante der Kemschicht des zweiten Stapels sein. Dadurch kann eine Dicke einer isolierenden Schicht vorteilhaft reduziert werden.

In einem Ausführungsbeispiel kann eine Impedanz des ersten Leiterbahnabschnitts 130 identisch zu einer Impedanz des zweiten Leiterbahnabschnitts 132 sein. Dadurch kann insbesondere eine Anordnung von verschiedenen Komponenten auf der Leiterplatte ohne Fehlanpassungen, Reflektionen und Leistungsverlust erfolgen.

In einem Ausführungsbeispiel kann die Leiterplatte ferner eine Verbindungsschicht umfassen. Die Verbindungsschicht kann zwischen dem ersten Stapel und dem zweiten Stapel angeordnet sein. Die Verbindungsschicht kann eine Verbindung zwischen verschiedenen Stapeln des Schichtstapel 100 herstellen. Die Verbindungsschicht kann aus Glasfasergewebe und Harz bestehen. Die Verbindungsschicht kann als Verbindung zwischen den einzelnen Stapeln der Leiterplatte verwendet werden, beispielweise, um eine elektrisch und thermisch leitende Verbindung herzustellen. Die Verbindungsschicht kann eine bessere mechanische Stabilität und eine höhere Zuverlässigkeit bei hohen Temperaturen ermöglichen.

In einem Ausführungsbeispiel kann der Schichtstapel 100 einen zwischen dem ersten Stapel und dem zweiten Stapel angeordneten dritten Stapel umfassen. Der dritte Stapel kann eine erste Leitschicht, eine zweite Leitschicht der Mehrzahl an Leitschichten und eine zwischen der ersten Leitschicht und der zweiten Leitschicht angeordnete Kemschicht der Mehrzahl an Kernschichten umfassen. Der dritte Stapel kann eine Aussparung im ersten Bereich und eine weitere Aussparung im zweiten Bereich aufweisen. Die Leiterbahn kann einen dritten Leiterbahnabschnitt in einem dritten Bereich umfassen. Eine Abmessung des dritten Leiterbahnabschnitts kann verschieden von einer Abmessung des ersten Leiterbahnabschnitts und einer Abmessung des zweiten Leiterbahnabschnitts. Dadurch kann die Leiterplatte für drei verschiedene Komponente designt werden. Prinzipiell kann die Leiterplatte für eine Anzahl x von verschiedenen Komponenten designt werden. Die Anzahl x ist hierbei gegeben die durch maximale Anzahl an Kernschichten bzw. Stapeln.

Die isolierende Schicht kann eine Dicke von mindestens 0,05 mm, oder mindestens 1 mm oder mindestens 2 mm und/oder maximal von 10 mm oder maximal 6 mm oder maximal 4 mm aufweisen. Eine Leitschicht kann eine Dicke von mindestens 10 µm, oder mindestens 40 µm oder mindestens 70 µm und/oder maximal von 300 µm oder maximal 200 µm oder maximal 100 µm aufweisen. Eine Kemschicht kann eine Dicke von mindestens 50 µm oder mindestens 80 µm oder mindestens 120 µm und/oder maximal 300 µm oder maximal 220 µm oder maximal 140 µm aufweisen.

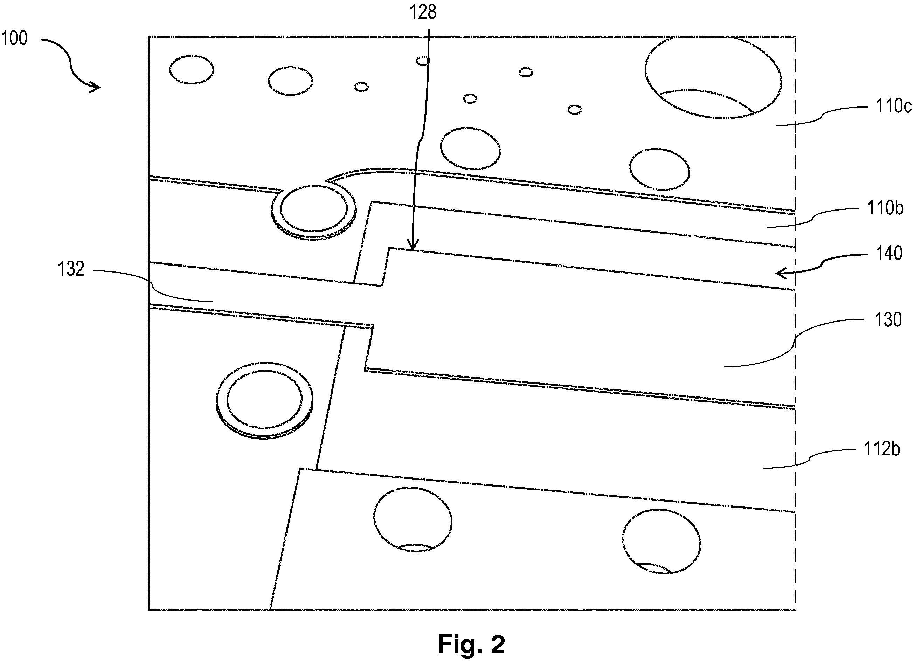

Weitere Einzelheiten und Aspekte werden im Zusammenhang mit den unten beschriebenen Ausführungsbeispielen erwähnt. Das in Fig. 1 gezeigte Ausführungsbeispiel kann ein oder mehrere optionale zusätzliche Merkmale umfassen, die einem oder mehreren Aspekten entsprechen, die im Zusammenhang mit dem vorgeschlagenen Konzept oder einem oder mehreren unten beschriebenen Ausführungsbeispielen (z. B. Fig. 2 - 5) erwähnt wurden.

Fig. 2 zeigt eine schematische Quersicht eines Schichtstapels 100 einer Leiterplatte. Der Schichtstapel kann identisch zu dem Schichtstapel aus Fig. 1 sein. In Fig. 2 sind eine Leiterbahnschicht 110c, eine ausgesparte Leitschicht 110b und eine Kemschicht 112b zu sehen. Ferner ist die Aussparung 140 der ausgesparten Leitschicht 110b erkennbar. Die Leiterbahnschicht 110c umfasst die Leiterbahn 128. Die Leiterbahn 128 umfasst den ersten Leiterbahnabschnitt 130 und den zweiten Leiterbahnabschnitt 132. Der erste Bereich (siehe Fig. 1a und Fig. 1b) kann verschieden von einem Bereich der Aussparung 140 sein. Abweichend von Fig. 2 kann der erste Bereich auch identisch zu dem Bereich der Aussparung 140 sein. In der Queransicht ist der für die Impedanz angepasste Übergang, z. B. ein Sprung einer Breite der Leiterbahn 128, zu erkennen. Durch diesen Sprung, oder allgemein die Veränderung der Breite der Leiterbahn im Bereich der Aussparung 140, kann die Leiterplatte bei konstanter Systemimpedanz an Komponenten mit verschiedenen Kontaktbereichen angepasst werden.

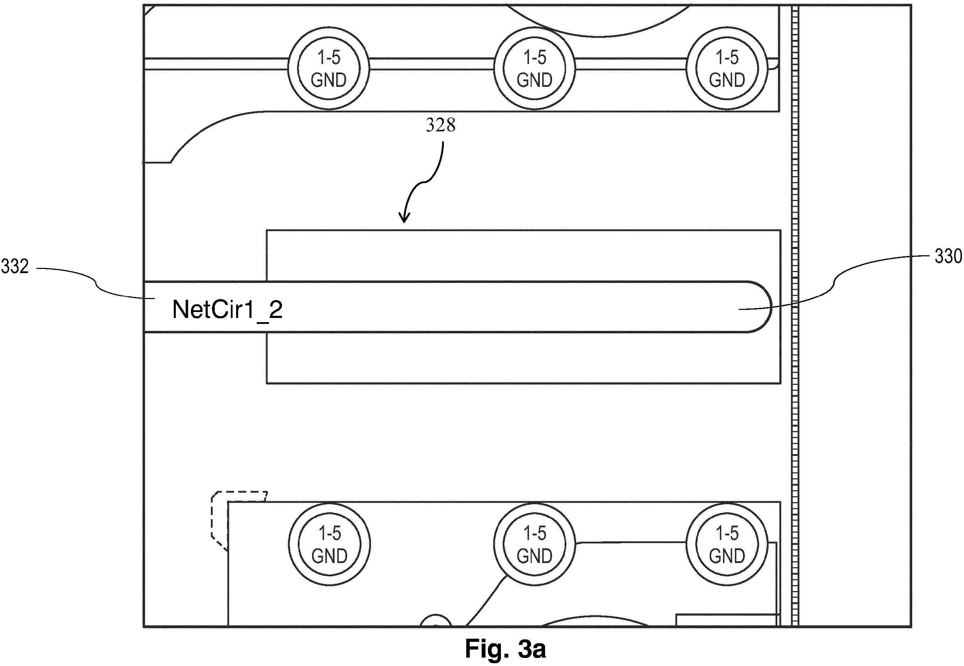

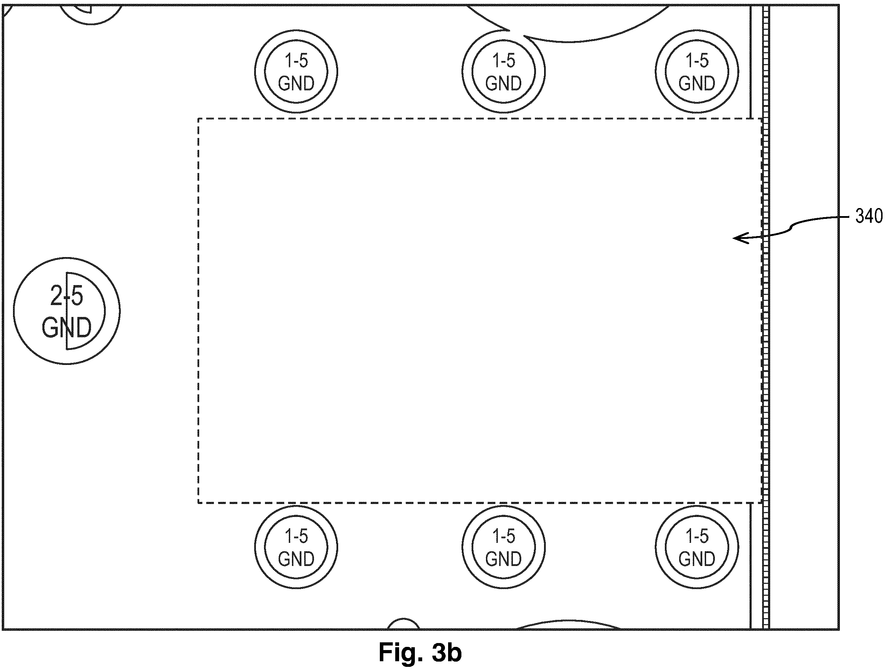

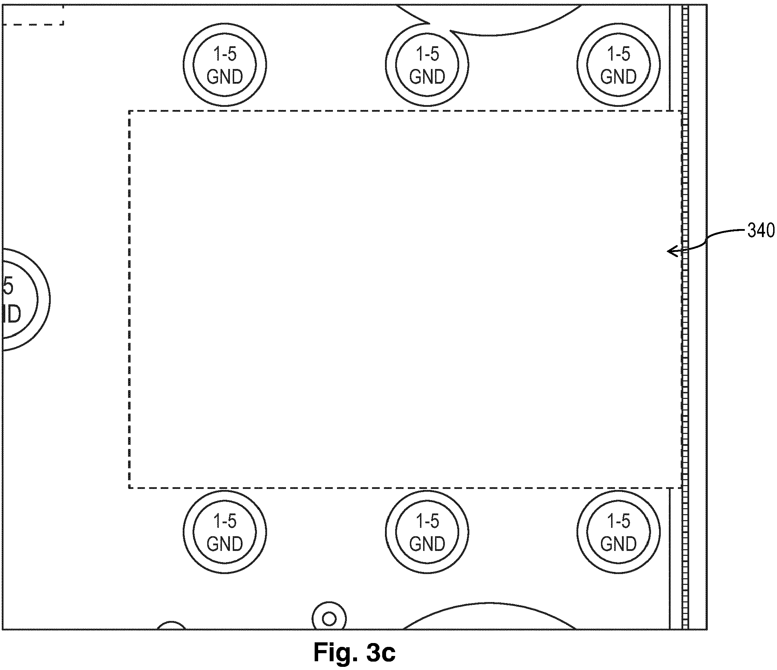

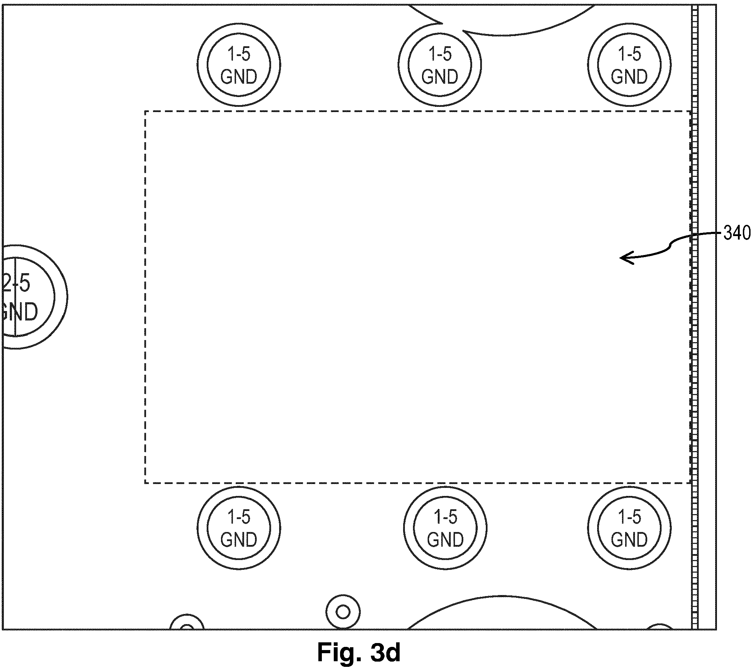

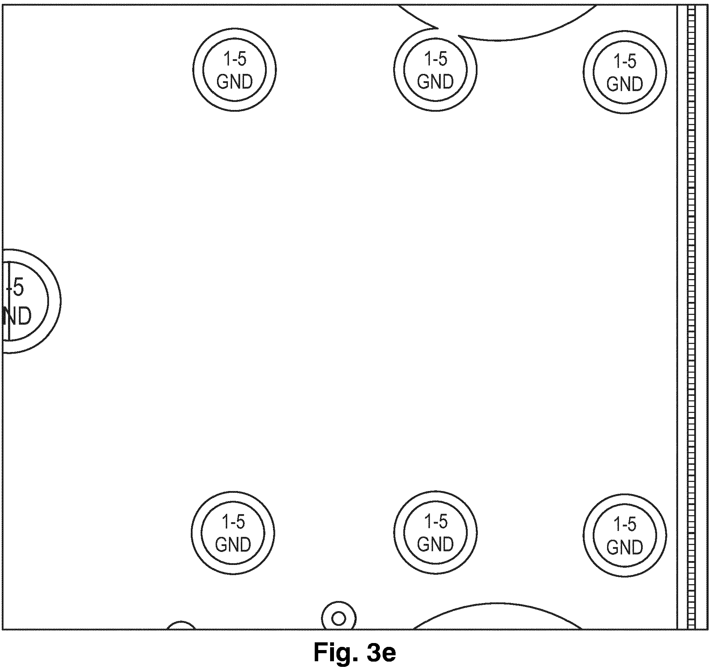

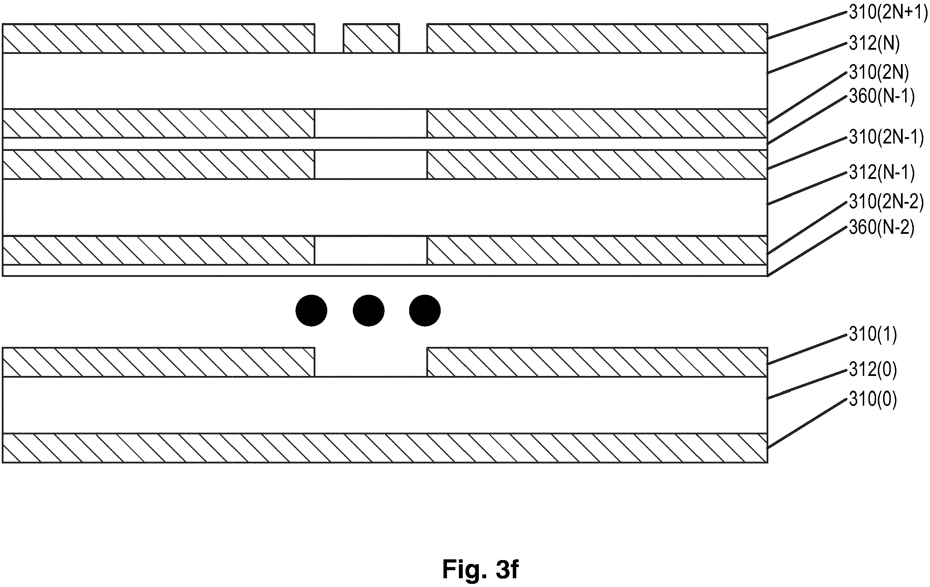

Weitere Einzelheiten und Aspekte werden im Zusammenhang mit den unten und/oder oben beschriebenen Ausführungsbeispielen erwähnt. Das in Fig. 2 gezeigte Ausführungsbeispiel kann ein oder mehrere optionale zusätzliche Merkmale umfassen, die einem oder mehreren Aspekten entsprechen, die im Zusammenhang mit dem vorgeschlagenen Konzept oder einem oder mehreren oben (z. B. Fig. 1) und/oder unten beschriebenen Ausführungsbeispielen (z. B. Fig. 3 - 5) erwähnt wurden.

Figs. 3a-3e zeigen schematische Draufsicht auf verschiedene Stapel eines Schichtstapels. Der Schichtstapel umfasst fünf Stapel. Jede Figs. 3a-3e zeigt eine schematische Draufsicht auf einen Stapel. Jeder Stapel kann, wie oben beschrieben, eine erste Leitschicht, eine zweite Leitschicht und eine Kemschicht umfassen. Fig. 3e zeigt den untersten Stapel und Fig. 3a den obersten Stapel. Der Stapel aus Fig. 3b ist oberhalb des Stapels aus Fig. 3c angeordnet. Der Stapel aus Fig. 3d ist unterhalb des Stapels aus Fig. 3e und oberhalb des Stapels aus Fig. 3c angeordnet.

Fig. 3a zeigt einen obersten Stapel des Schichtstapels. Der oberste Stapel umfasst die Leiterbahn 330. Die Leiterbahn 328 umfasst einen ersten Leiterbahnabschnitt 330 und einen zweiten Leiterbahnabschnitt 332. Wie in den Fig. 3b-3d zu sehen ist weisen die mittleren Stapel eine Aussparung 140 auf. Durch diese Aussparung kann die Impedanz des breiteren Leiterbahnabschnitts 330 geeignet angepasst werden. Fig. 3e zeigt eine vollflächige Masseschicht, die von dem untersten Schichtstapel umfasst ist. Die Masseschicht weist keine Aussparung auf.

Fig. 3f zeigt eine beispielshafte Querschnittsansicht eines Schichtstapels, beispielsweise des Schichtstapels der Figs. 3a-3e. Wie bereits erwähnt kann jeder Stapel zwei Leitschichten 310(x) und eine Kemschicht umfassen 312(x). Für den Schichtstapel aus den Figs. 3a-3e ist N = 4. Wie in Fig. 3f zu erkennen ist, kann lediglich die unterste Leitschicht 310(0) vollflächig ausgebildet sein. Alle anderen Leitschichten können eine Aussparung aufweisen. Der Leiterbahnabschnitt, der im Bereich der Aussparung geformt ist, weist durch für eine Impedanzberechnung der Leiterbahn durch die Mehrzahl an relevanten Kernschichten 310(0)-210(N) eine veränderte Charakteristik auf, als ein der Bereich neben der Aussparung. Neben der Aussparung wird die Leiterbahn in der Leitschicht (bzw. der Leiterbahnschicht) 310(N+1) durch die Leiterschicht 310(N) abgeschirmt. Für diesen Bereich ist also lediglich die oberste Kernschicht 312(N) für eine Impedanzberechnung von Relevanz.

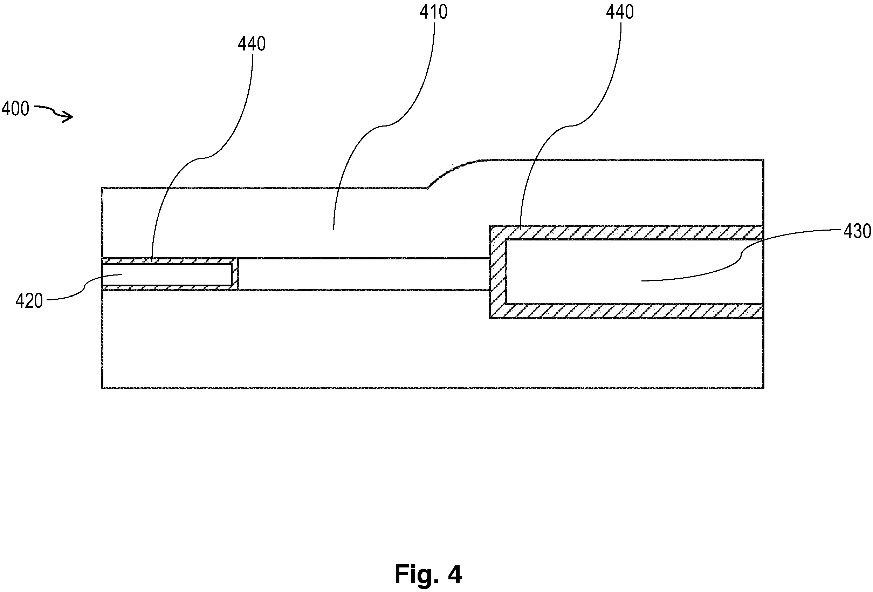

Weitere Einzelheiten und Aspekte werden im Zusammenhang mit den unten und/oder oben beschriebenen Ausführungsbeispielen erwähnt. Das in Fig. 3 gezeigte Ausführungsbeispiel kann ein oder mehrere optionale zusätzliche Merkmale umfassen, die einem oder mehreren Aspekten entsprechen, die im Zusammenhang mit dem vorgeschlagenen Konzept oder einem oder mehreren oben (z. B. Fig. 1 - 2) und/oder unten beschriebenen Ausführungsbeispielen (z. B. Fig. 4 - 5) erwähnt wurden.

Fig. 4 zeigt eine elektronische Vorrichtung 400 umfassend eine Leiterplatte 410. Die Leiterplatte 410 kann eine Leiterplatte wie oben beschrieben, beispielsweise in Fig. 1, Fig. 2 und/oder Fig. 3, sein. Auf der Leiterplatte 410 können eine erste Komponenten 420 und eine zweite Komponente 430 angeordnet sein. Die zweite Komponenten 420 kann einen Kontaktbereich aufweisen, der eine kleinere Breite hat als ein Kontaktbereich der ersten Komponente 430. Beispielsweise kann die erste Komponente 430 eine Komponente für den Hochleistungsbetrieb sein, beispielsweise ein Hochleistungssteckverbinder für einen Hochfrequenzverstärker sein. Die erste Komponente 430 kann im dem ersten Bereich mit dem ersten Leiterbahnabschnitt kontaktiert werden. Durch den breiteren ersten Leiterbahnabschnitt im Vergleich zum zweiten Leiterbahnabschnitt kann ein Kontakt zwischen der ersten Komponente 430 und der Leiterplatte 410 verbessert werden. Die erste Komponente 430 und/oder die zweite Komponente 420 können mit einem Verbindungsmittel 440, beispielsweise einer Lötpaste, einer Lotkugel elektrisch und/oder mechanisch mit der Leiterplatte 410 kontaktiert werden.

Die Leiterplatte 410 umfasst einen Schichtstapel. Der Schichtstapel kann einen ersten Stapel und einen auf dem ersten Stapel angeordneten zweiten Stapel umfassen. Jeder Stapel kann eine erste Leitschicht, eine zweite Leitschicht und eine zwischen der ersten Leitschicht und der zweiten Leitschicht angeordnete Kemschicht umfassen. Die erste Leitschicht und die zweite Leitschicht können elektrisch leitfähig sein. Eine zweite Leitschicht des ersten Stapels und eine erste Leitschicht des zweiten Stapels können in einem ersten Bereich ausgespart sein. Eine zweite Leitschicht des zweiten Stapels kann eine Leiterbahn umfassen. Die Leiterbahn kann einen ersten Leiterbahnabschnitt in dem ersten Bereich und einen zweiten Leiterbahnabschnitt in einem zweiten Bereich aufweisen.

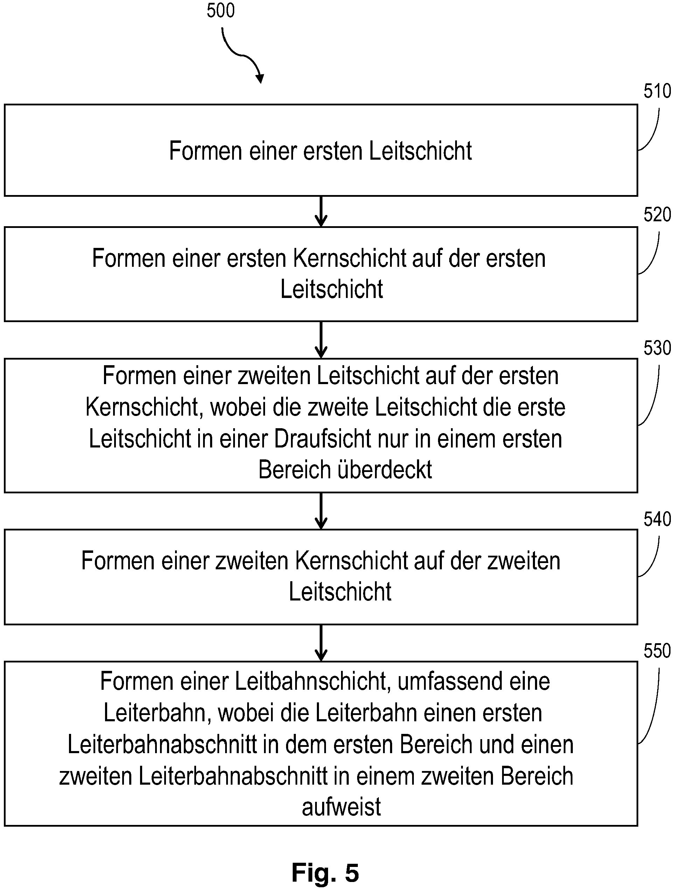

Weitere Einzelheiten und Aspekte werden im Zusammenhang mit den unten und/oder oben beschriebenen Ausführungsbeispielen erwähnt. Das in Fig. 4 gezeigte Ausführungsbeispiel kann ein oder mehrere optionale zusätzliche Merkmale umfassen, die einem oder mehreren Aspekten entsprechen, die im Zusammenhang mit dem vorgeschlagenen Konzept oder einem oder mehreren oben (z. B. Fig. 1 - 3) und/oder unten beschriebenen Ausführungsbeispielen (z. B. Fig. 5) erwähnt wurden.

Fig. 5 zeigt eine schematische Darstellung eines Beispiels eines Verfahrens 500. Das Verfahren 500 umfasst Formen 510 einer ersten Leitschicht und Formen 520 einer ersten Kernschicht auf der ersten Leitschicht. Ferner umfasst das Verfahren 500 Formen 530 einer zweiten Leitschicht auf der ersten Kemschicht. Die zweite Leitschicht überdeckt die erste Leitschicht in einer Draufsicht nur in einem ersten Bereich und Formen 540 einer zweiten Kemschicht auf der zweiten Leitschicht. Ferner umfasst das Verfahren 500 Formen 550 einer Leitbahnschicht, umfassend eine Leiterbahn. Die Leiterbahn weist einen ersten Leiterbahnabschnitt in dem ersten Bereich und einen zweiten Leiterbahnabschnitt in einem zweiten Bereich auf. Das Verfahren 500 kann beispielsweise verwendet werden um eine Leiterplatte wie oben beschrieben herzustellen.

Weitere Einzelheiten und Aspekte werden im Zusammenhang mit den oben beschriebenen Ausführungsbeispielen erwähnt. Das in Fig. 5 gezeigte Ausführungsbeispiel kann ein oder mehrere optionale zusätzliche Merkmale umfassen, die einem oder mehreren Aspekten entsprechen, die im Zusammenhang mit dem vorgeschlagenen Konzept oder einem oder mehreren oben (z. B. Fig. 1 - 4) beschriebenen Ausführungsbeispielen erwähnt wurden.

Weitere Ausführungsbeispiele sind Computerprogramme zur Durchführung eines der hierin beschriebenen Verfahren, wenn das Computerprogramm auf einem Computer, einem Prozessor, oder einer programmierbaren Hardwarekomponente abläuft. Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-Ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einer programmierbaren Hardwarekomponente derart zusammenwirken können oder zusammenwirken, dass das jeweilige Verfahren durchgeführt wird.

Eine programmierbare Hardwarekomponente kann durch einen Prozessor, einen Computerprozessor (CPU = Central Processing Unit), einen Grafikprozessor (GPU = Graphics Processing Unit), einen Computer, ein Computersystem, einen anwendungsspezifischen integrierten Schaltkreis (ASIC = Application-Specific Integrated Circuit), einen integrierten Schaltkreis (IC = Integrated Circuit), ein Ein-Chip-System (SOC = System on Chip), ein programmierbares Logikelement oder ein feldprogrammierbares Gatterarray mit einem Mikroprozessor (FPGA = Field Programmable Gate Array) gebildet sein.

Das digitale Speichermedium kann daher maschinen- oder computerlesbar sein. Manche Ausführungsbeispiele umfassen also einen Datenträger, der elektronisch lesbare Steuersignale aufweist, die in der Lage sind, mit einem programmierbaren Computersystem oder einer programmierbare Hardwarekomponente derart zusammenzuwirken, dass eines der hierin beschriebenen Verfahren durchgeführt wird. Ein Ausführungsbeispiel ist somit ein Datenträger (oder ein digitales Speichermedium oder ein computerlesbares Medium), auf dem das Programm zum Durchführen eines der hierin beschriebenen Verfahren aufgezeichnet ist.

Allgemein können Ausführungsbeispiele der vorliegenden Erfindung als Programm, Firmware, Computerprogramm oder Computerprogrammprodukt mit einem Programmcode oder als Daten implementiert sein, wobei der Programmcode oder die Daten dahin gehend wirksam ist bzw. sind, eines der Verfahren durchzuführen, wenn das Programm auf einem Prozessor oder einer programmierbaren Hardwarekomponente abläuft. Der Programmcode oder die Daten kann bzw. können beispielsweise auch auf einem maschinenlesbaren Träger oder Datenträger gespeichert sein. Der Programmcode oder die Daten können unter anderem als Quellcode, Maschinencode oder Bytecode sowie als anderer Zwischencode vorliegen.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Eine Leiterplatte, umfassend:
einen Schichtstapel (100), umfassend eine Mehrzahl an Kernschichten (112a; 112b) und eine Mehrzahl an Leitschichten (110a; 110b), wobei jede Leitschicht der Mehrzahl an Leitschichten elektrisch leitfähig ist; und
eine auf dem Schichtstapel angeordnete Leiterbahnschicht (110c), umfassend eine Leiterbahn (128), wobei die Leiterbahn (128) einen ersten Leiterbahnabschnitt (130) in einem ersten Bereich (120) und einen zweiten Leiterbahnabschnitt (132) in einem zweiten Bereich (122) aufweist,
wobei eine ausgesparte Leitschicht (110b) der Mehrzahl an Leitschichten in dem ersten Bereich (120) eine Aussparung (140) aufweist.

2. Eine Leiterplatte nach Anspruch 1, wobei:
der Schichtstapel einen ersten Stapel und einen auf dem ersten Stapel angeordneten zweiten Stapel umfasst, wobei
der erste Stapel und der zweite Stapel jeweils eine erste Leitschicht, eine zweite Leitschicht der Mehrzahl an Leitschichten und eine zwischen der ersten Leitschicht und der zweiten Leitschicht angeordnete Kernschicht der Mehrzahl an Kernschichten umfasst; wobei
die zweite Leitschicht des ersten Stapels und die erste Leitschicht des zweiten Stapels weisen in dem ersten Bereich eine Aussparung auf, wobei die ausgesparte Leitschicht identisch ist zu der zweiten Leitschicht des ersten Stapels oder der ersten Leitschicht des zweiten Stapels; und wobei
die zweite Leitschicht des zweiten Stapels die Leiterbahnschicht formt.

3. Die Leiterplatte nach einem der vorhergehenden Ansprüche, wobei
eine Impedanz des ersten Leiterbahnabschnitts (130) von einem Abstand des ersten Leiterbahnabschnitts (130) zu einer unausgesparten Leitschicht (110a) der Mehrzahl an Leitschichten und eine Impedanz des zweiten Leiterbahnabschnitts (132) von einem Abstand des zweiten Leiterbahnabschnitts (132) zu der ausgesparten Leitschicht (1 10b) der Mehrzahl an Leitschichten abhängt.

4. Die Leiterplatte nach einem der vorhergehenden Ansprüche, wobei
eine Breite der Leiterbahn (128) des ersten Leiterbahnabschnitts (130) geringer ist als eine Breite der Leiterbahn (128) des zweiten Leiterbahnabschnitts (132).

5. Die Leiterplatte nach einem der vorhergehenden Ansprüche, wobei
eine Impedanz des ersten Leiterbahnabschnitts (130) identisch ist zu einer Impedanz des zweiten Leiterbahnabschnitts (132).

6. Die Leiterplatte nach einem der Ansprüche 2-5, ferner umfassend
eine Verbindungsschicht, wobei die Verbindungsschicht zwischen dem ersten Stapel und des zweiten Stapels angeordnet ist.

7. Die Leiterplatte nach einem der Ansprüche 2-6, wobei
der Schichtstapel einen zwischen dem ersten Stapel und dem zweiten Stapel angeordneten dritten Stapel umfasst, wobei der dritte Stapel eine erste Leitschicht, eine zweite Leitschicht der Mehrzahl an Leitschichten und eine zwischen der ersten Leitschicht und der zweiten Leitschicht angeordnete Kernschicht der Mehrzahl an Kernschichten umfasst; wobei
der dritte Stapel eine Aussparung im ersten Bereich und eine weitere Aussparung im zweiten Bereich aufweist; wobei
die Leiterbahn (128) einen dritten Leiterbahnabschnitt in einem dritten Bereich umfasst, eine Abmessung des dritten Leiterbahnabschnitts verschieden von einer Abmessung des ersten Leiterbahnabschnitts und einer Abmessung des zweiten Leiterbahnabschnitts.

8. Die Leiterplatte nach einem der Ansprüche 2-7, wobei
eine Dielektrizitätskonstante der Kemschicht des ersten Stapels identisch ist zu einer Dielektrizitätskonstante der Kemschicht des zweiten Stapels.

9. Die Leiterplatte nach einem der Ansprüche 2-7, wobei
eine Dielektrizitätskonstante der Kemschicht des ersten Stapels verschieden ist von einer Dielektrizitätskonstante der Kemschicht des zweiten Stapels.

10. Elektronische Vorrichtung (400), umfassend:
eine Leiterplatte (410), umfassend:
einen Schichtstapel, umfassend einen ersten Stapel und einen auf dem ersten Stapel angeordneten zweiten Stapel, wobei
jeder Stapel eine erste Leitschicht, eine zweite Leitschicht und eine zwischen der ersten Leitschicht und der zweiten Leitschicht angeordnete Kemschicht umfasst, wobei die erste Leitschicht und die zweite Leitschicht elektrisch leitfähig sind; wobei
eine zweite Leitschicht des ersten Stapels und eine erste Leitschicht des zweiten Stapels in einem ersten Bereich ausgespart sind, und wobei
eine zweite Leitschicht des zweiten Stapels eine Leiterbahn umfasst, die Leiterbahn weist einen ersten Leiterbahnabschnitt in dem ersten Bereich und einen zweiten Leiterbahnabschnitt in einem zweiten Bereich auf;
eine erste Komponente (430); und
eine zweite Komponente (420).

11. Die Vorrichtung (400) nach Anspruch 10, wobei
ein Kontaktbereich der ersten Komponenten (430) eine größere Breite aufweist als ein Kontaktbereich der zweiten Komponenten (420).

12. Ein Verfahren (500) zur Herstellung einer Leiterplatte, umfassend:
Formen (510) einer ersten Leitschicht;
Formen (520) einer ersten Kemschicht auf der ersten Leitschicht;
Formen (530) einer zweiten Leitschicht auf der ersten Kernschicht, wobei die zweite Leitschicht die erste Leitschicht in einer Draufsicht nur in einem ersten Bereich überdeckt;
Formen (540) einer zweiten Kernschicht auf der zweiten Leitschicht; und
Formen (550) einer Leitbahnschicht, umfassend eine Leiterbahn, wobei die Leiterbahn einen ersten Leiterbahnabschnitt in dem ersten Bereich und einen zweiten Leiterbahnabschnitt in einem zweiten Bereich aufweist.
